# EUROPÄISCHE PATENTSCHRIFT

(11) **EP 3 408 425 B1**
(45) Veröffentlichungstag und Bekanntmachung des Hinweises auf die Patenterteilung: **10.03.2021**
(21) Anmeldenummer: 17703037.6
(22) Anmeldetag: 17.01.2017
(51) Int. Cl.: C23C 16/54, C23C 16/44, C23C 16/458, C23C 14/56, C23C 16/50

(54) **VERFAHREN ZUM OBERFLÄCHENBESCHICHTEN EINES BAUTEILS UNTER VAKUUM**
PROCESS FOR SURFACE-COATING A COMPONENT UNDER VACUUM
PROCÉDÉ DE REVÊTEMENT DE LA SURFACE D'UNE PIÈCE SOUS VIDE

(30) Priorität: 25.01.2016 DE 102016101197
(43) Veröffentlichungstag der Anmeldung: 05.12.2018
(73) Patentinhaber: HELLA GmbH & Co. KGaA, 59557 Lippstadt (DE)
(72) Erfinder: ROCHOTZKI, Ralf, 59557 Lippstadt (DE); HARTMANN, Frank, 59555 Lippstadt (DE); RATH, Egbert, 59556 Lippstadt (DE); EICKENBUSCH, Martin, 59510 Lippetal (DE)
(86) Internationale Anmeldenummer: PCT/EP2017/050872
(87) Internationale Veröffentlichungsnummer: WO 2017/129442

(56) Entgegenhaltungen:
- DE-A1- 10 314 067
- DE-A1-102011 009 057
- DE-B4- 19 624 609
- US-A1- 2001 033 900
- US-A1- 2014 349 469

## Beschreibung

Die vorliegende Erfindung betrifft ein Verfahren zum Oberflächenbeschichten eines Bauteils unter Vakuum mittels einer Vakuumbeschichtungsanlage, wobei das Verfahren wenigstens zwei der nachfolgend genannten Prozessschritte umfasst: a) Plasmaaktivieren der zu beschichtenden Oberfläche des Bauteils in einer evakuierten Plasmaaktivierungskammer und/oder b) Aufbringen der Beschichtung in einer evakuierten Beschichtungskammer und/oder c) Plasmapolymerisation zur Erzeugung einer Schutzschicht auf der aufgebrachten Beschichtung in einer evakuierten Plasmapolymerisationskammer.

### STAND DER TECHNIK

Verfahren zum Oberflächenbeschichten eines Bauteils mittels einer Vakuumbeschichtungsanlage werden unter anderem ausgeführt, um die Oberfläche von 3D-Bauteilen zu metallisieren. Beispielsweise werden Reflektoren von Scheinwerfern oder dekorative Bauteile wie Sichtblenden und dergleichen mit einer Metallschicht überzogen. Abhängig vom zu beschichtenden Werkstoff, beispielsweise Aluminium oder Edelstahl, erfolgt optional eine vorgelagerte Plasmaaktivierung, beispielsweise mittels eines CVD-Verfahrens in einer ersten Kammer, die zur Ausführung des Verfahrens evakuiert wird. Anschließend erfolgt das eigentliche Beschichten, das unabhängig vom zu beschichtenden Werkstoff einen notwendigen Prozessschritt darstellt, beispielsweise also das Aufdampfen oder das Aufsputtern der metallischen Reflexionsschicht, insbesondere mittels des PVD-Verfahrens unter Vakuum. Anschließend kann eine Plasmapolymerisation unter Vakuum zur Erzeugung einer Schutzschicht erfolgen, die wiederum auf dem CVD-Verfahren beruht. Die Notwendigkeit des Verfahrensschrittes der Plasmapolymerisation ist dabei auch wieder abhängig vom zu beschichtenden Werkstoff.

Heute übliche Ausführungen von Vakuumbeschichtungsanlagen bestehen entweder aus einer einzigen entsprechend groß ausgeführten Prozesskammer, in der die verschiedenen Prozessschritte nacheinander realisiert werden, oder es sind mehrere Prozesskammern vorgesehen, in denen die Prozessschritte weitgehend parallel abgearbeitet werden und die behandelten Teile von Kammer zu Kammer transportiert werden. In beiden Fällen erfolgt die Prozessführung ohne Unterbrechung des Vakuums. Finden mehrere Prozesskammern Anwendung, so müssen zwischen den einzelnen Kammern Schleusensysteme vorgesehen werden, wenn das Vakuum in der betreffenden Kammer wenigstens überwiegend erhalten bleiben soll. Unter einem Vakuum wird vorliegend ein Druck unterhalb des Atmosphärendruckes verstanden, der hinreichend ist, den entsprechenden Prozessschritt auszuführen. Folglich bezeichnet das Evakuieren vorliegend jeden Grad der Druckabsenkung unter einen außerhalb der Prozesskammer vorherrschenden Druck.

Beispielsweise zeigt die DE 103 52 144 B4 ein Mehrkammerprinzip einer Vakuumbeschichtungsanlage, wobei zwischen den einzelnen Kammern aufwändige Schleuseneinrichtungen vorgesehen werden. Ebenfalls sind Schleusen zwischen einzelnen Kammervolumina aus der DE 198 08 163 C1 bekannt.

Weitere Beschichtungsanlagen mit einem Mehrkammerprinzip sind aus der DE 196 24 609 B4 oder aus der US 65 54 980 B1 bekannt Weiterer relevanter Stand der Technik ist in der Druckschrift DE 103 14 067 A1 beschrieben.

Die Umsetzung der Aufrechterhaltung eines Vakuums für sämtliche aufeinanderfolgenden Prozessschritte führt dazu, dass bei Mehrkammeranlagen der Transport der Bauteile von Prozesskammer zu Prozesskammer ebenfalls unter Vakuum erfolgen muss. Dies lässt sich durch technisch aufwändige Konstruktionen wie entsprechende Vakuumdurchführungen für die mechanischen Bewegungen der Bauteile lösen, diese Lösung ist jedoch kostenintensiv und mit hohen Wartungsaufwänden verbunden.

Bei den Lösungen mit nur einer Prozesskammer, in der die Prozesse nacheinander ablaufen, sind der Miniaturisierung Grenzen gesetzt, die insbesondere aus den unterschiedlichen prozesstechnischen Erfordernissen resultieren, da nicht jeder Prozess den gleichen Raum erfordert, insbesondere nicht mit gleichen Aggregaten (z.B. Elektroden) betrieben werden kann. Moderne Fertigungskonzepte der Einzelteilbeschichtung nach der Fließfertigung, also dem sogenannten "One-Piece-Flow", werden daher nicht in ausreichendem Maße unterstützt. Die sequentielle Abarbeitung der verschiedenen technologischen Schritte in einer Kammer kann zusätzlich zu einer wechselseitigen Beeinflussung und Kontamination der Prozesse führen, so dass sich das Prozessergebnis durchaus verschlechtern kann.

Bei Mehrkammeranlagen und bei einer parallelen Abarbeitung der verschiedenen technologischen Prozessschritte bei insbesondere automatisierten Vakuumbeschichtungsanlagen mit extrem kurzen Taktzeiten, also beispielsweise mit weniger als einer Minute, kann eine hohe Ausbringung erreicht werden, jedoch ist der anlagentechnische Aufwand für die entsprechende Durchschleusung des Bauteils von Kammer zu Kammer aufwändig.

Ein Beispiel hierzu zeigt die DE 197 04 947 A1. Hieraus bekannt sind ein Verfahren und eine Vorrichtung zur Schutzbeschichtung von Verspiegelungsschichten mit mehreren zweiteilig aufgebauten Prozesskammern. Die inneren Teile der Prozesskammern sind an einem Rundtakttisch angeordnet und zur Aufnahme des Bauteils ausgebildet. Diese inneren Prozesskammerteile können durch Verdrehen des Rundtakttisches folglich mit den aufeinander folgenden Stationen in Überdeckung gebracht werden, sodass die zu beschichtenden Bauteile von Station zu Station bewegt werden. Dabei bleibt das Vakuum beim Wechsel der Stationen erhalten, wofür am Rundtakttisch ein Innenwandzylinder eingerichtet ist, in dem die inneren Teile der Prozesskammern eingebracht sind. Der Innenwandzylinder ist mit dem Rundtakttisch drehbeweglich verbunden und läuft in einer kreiszylindrisch ausgestalteten Volumenkammerwand, in der die äußeren Teile der Prozesskammern stationsweise eingerichtet sind. So können beispielsweise alle 90° um die Rundtaktachse die inneren mit den äußeren Teilen der Prozesskammern in Überdeckung gebracht werden, wobei beispielsweise drei Prozessstationen vorgesehen sind und bei einer Station kann eine Entnahmemöglichkeit vorgesehen werden. Der taktweise Wechsel der inneren und äußeren Kammerteile zueinander unter Beibehaltung des Unterdrucks in den Kammerteilen erfordert einen erheblichen anlagentechnischen Aufwand, da insbesondere beim Wechsel der inneren und äußeren Kammerteile erhebliche Dichtungsprobleme überwunden werden müssen, um das Vakuum aufrecht zu erhalten.

### OFFENBARUNG DER ERFINDUNG

Aufgabe der Erfindung ist die Weiterbildung eines Verfahrens zum Oberflächenbeschichten eines Bauteils unter Vakuum sowie die Bereitstellung einer solchen Vakuumbeschichtungsanlage, wobei der anlagentechnische Aufwand möglichst minimiert werden soll, und wobei eine parallele Abarbeitung einzelner Verfahrensschritte an mehreren Bauteilen möglich sein soll. Insbesondere soll das Verfahren basierend auf einem Mehrkammerprinzip der Vakuumbeschichtungsanlage weiter verbessert werden.

Diese Aufgabe wird ausgehend von einem Verfahren zum Oberflächenbeschichten eines Bauteils gemäß dem Oberbegriff des Anspruches 1 und ausgehend von einer Vakuumbeschichtungsanlage gemäß dem Oberbegriff des Anspruches 7 mit den jeweils kennzeichnenden Merkmalen gelöst. Vorteilhafte Weiterbildungen der Erfindung sind in den abhängigen Ansprüchen angegeben.

Das erfindungsgemäße Verfahren sieht vor, dass zwischen wenigstens zwei der genannten Prozessschritte die Plasmaaktivierungskammer und/oder die Beschichtungskammer und/oder die Plasmapolymerisationskammer belüftet und geöffnet werden, und das Bauteil dem nachfolgenden Prozessschritt zugeführt wird. Unter Inkaufnahme einer verringerten Ausbringung der Anlage kann bei speziellen Behandlungsprozessen auf einzelne Prozessschritte verzichtet werden.

Die Erfindung geht von dem Gedanken aus, eine aufwändige Schleusentechnik zwischen den Prozesskammern damit zu vermeiden, dass nach jedem ausgeführten Prozessschritt die jeweilige Prozesskammer belüftet und geöffnet wird. Das Belüften und Öffnen der drei Prozesskammern erfolgt vorzugsweise zeitgleich, so dass in der Vakuumbeschichtungsanlage immer wenigstens zwei oder drei Bauteile gleichzeitig bearbeitet werden. Ein erstes Bauteil wird in der Plasmaaktivierungskammer mit Plasma aktiviert, ein zweites Bauteil wird in der Beschichtungskammer beschichtet und beispielsweise ein drittes Bauteil wird in der Plasmapolymerisationskammer der Plasmapolymerisation unterzogen, um eine entsprechende Schutzschicht zu erzeugen. Dabei können auch nur zwei der drei Kammern zur Anwendung und damit zur Ausgestaltung der Anlage zur Anwendung kommen, wobei die Beschichtungskammer eine für alle Prozessarten notwendige Kammer darstellt.

Der besondere Vorteil des erfindungsgemäßen Verfahrens liegt in der hohen Ausbringung, da alle drei Kammern zeitgleich schließen, evakuiert werden, belüftet werden und wieder geöffnet werden, so dass die Bauteile jeweils eine Kammer weitergeführt werden können. Die Belüftung und Öffnung der jeweiligen Kammer nach den einzelnen Prozessschritten erübrigt die Ausgestaltung von Schleusensystemen zwischen den Kammern, da jedoch die einzelnen Kammern zeitgleich evakuiert werden können, entstehen keine zeitlichen Nachteile durch die stets erneut erforderliche Evakuierung. Beispielsweise ist nach dem Plasmaaktivieren vorgesehen, die Plasmaaktivierungskammer zu belüften und zu öffnen und das Bauteil kann aus der Plasmaaktivierungskammer in die Beschichtungskammer überführt werden und/oder es ist vorgesehen, dass nach dem Aufbringen der Beschichtung die Beschichtungskammer belüftet und geöffnet wird und das Bauteil wird aus der Beschichtungskammer in die Plasmapolymerisationskammer überführt.

Ein weiterer Verfahrensvorteil wird dadurch erreicht, dass mehrere Bauteile in einer Taktfolge hintereinander in der Vakuumbeschichtungsanlage beschichtet werden, wobei das Evakuieren, das Belüften und das Öffnen der Plasmaaktivierungskammer, der Beschichtungskammer und der Plasmapolymerisationskammer jeweils gleichzeitig ausgeführt werden. Wenn die Bauteile an die Vakuumbeschichtungsanlage geliefert werden, werden diese zunächst in die Plasmaaktivierungskammer eingegeben, während das vorangehende Bauteil bereits in die Beschichtungskammer überführt wird und das diesem Bauteil vorangehende Bauteil in die Plasmapolymerisationskammer überführt wird. Diese Taktfolge wird Bauteil für Bauteil weitergeführt, so dass sich die Taktfrequenz nach der Taktfolge der jeweiligen Überführung der Bauteile richtet. Die Dimensionierung der einzelnen Mittel zum Ausführen der Verfahrensschritte, also die Mittel zum Plasmaaktivieren, zum Aufbringen der Beschichtung und die Mittel zur Plasmapolymerisation werden zueinander so dimensioniert und mit Prozessparametern betrieben, dass die jeweiligen Prozessschritte im Wesentlichen die gleiche Prozessdauer beanspruchen.

Ein weiterer Vorteil wird erreicht, wenn das Vakuum in der Plasmaaktivierungskammer, in der Beschichtungskammer und in der Plasmapolymerisationskammer mittels einer gemeinsamen Vakuumpumpe gleichzeitig erzeugt wird. Die Vakuumpumpe kann als entsprechend groß dimensionierter Vorvakuumpumpstand ausgeführt werden und kammernah installiert sein, um möglichst kurze Rohrleitungen zwischen dem Pumpstand und den Kammern zu erzeugen. Über ein entsprechendes Rohrsystem sind dabei alle drei Kammern mit der Vakuumpumpe verbunden.

Weiterführend zur Evakuierung durch den Vorvakuumpumpstand kann vorgesehen werden, dass zur noch stärkeren Evakuierung der Beschichtungskammer eine Zusatzvakuumpumpe vorhanden ist, die nach der gemeinsamen Evakuierung der Kammern durch die Vorvakuumpumpe zur noch weiteren Evakuierung der Beschichtungskammer aktiviert wird, insbesondere mittels Öffnen eines Ventils. Zur Beschichtung ist ein Vakuum erforderlich, das einen noch niedrigeren Atmosphärendruck aufweist als das Vakuum in der Kammer zur Plasmaaktivierung und in der Kammer zur Plasmapolymerisation. Ein entsprechendes Schieberventil oder geeignetes Ventil anderer Bauart ist dabei zwischen dem Rohrsystem der Vorvakuumpumpe und der Beschichtungskammer vorgesehen, so dass die Zusatzvakuumpumpe lediglich noch mit der Beschichtungskammer fluidisch verbunden ist.

Mit weiterem Vorteil erfolgen die Prozessschritte des Einführens der Bauteile, des Evakuierens, des jeweiligen Prozessablaufes, des Belüftens und des Öffnens der drei Kammern zeitgleich, wofür die Vakuumbeschichtungsanlage entsprechend ausgelegt ist. Beispielsweise ist eine Öffnungs- und Schließmechanik vorgesehen, die eine Bewegung von zumindest Teilen aller drei Kammern gleichzeitig und mechanisch miteinander verbunden bewirkt.

Die Erfindung richtet sich weiterhin auf eine Vakuumbeschichtungsanlage zum Oberflächenbeschichten eines Bauteils unter Vakuum, aufweisend: eine Plasmaaktivierungskammer zum Plasmaaktiveren der zu beschichtenden Oberfläche des Bauteils; eine Beschichtungskammer zum Aufbringen der Beschichtung und eine Plasmapolymerisationskammer zur Erzeugung einer Schutzschicht auf der aufgebrachten Beschichtung mittels einer Plasmapolymerisation. Dabei weisen die Plasmaaktivierungskammer, die Beschichtungskammer und die Plasmapolymerisationskammer jeweils einen ersten Kammerteil auf, in dem Mittel zum Plasmaaktiveren, Mittel zum Aufbringen der Beschichtung und/oder Mittel zur Plasmapolymerisation ausgebildet sind, und jeweils einen zweiten Kammerteil, der zur Aufnahme des Bauteils ausgebildet ist. Erfindungsgemäß sind die zweiten Kammerteile gegen die ersten Kammerteile beweglich angeordnet und somit bei einem Wechsel der Bauteile zwischen wenigstens zwei Prozessschritten belüftbar, taktweise wechselbar, wieder schließbar und evakuierbar.

Die erfindungsgemäße Ausgestaltung der Vakuumbeschichtungsanlage wird dadurch weiter verbessert, dass nur eine Vakuumpumpe eingerichtet ist, insbesondere ein Vakuumpumpstand, mit der bzw. mit dem das Vakuum in der Plasmaaktivierungskammer, in der Beschichtungskammer und/oder in der Plasmapolymerisationskammer mittels der einen Vakuumpumpe gemeinsam und gleichzeitig erzeugbar ist. Die Vakuumpumpe kann als Vor- und/oder Feinvakuumpumpe dienen und es kann eine Zusatzvakuumpumpe vorgesehen sein, die die Beschichtungskammer noch weiter evakuiert. Insbesondere können die Vakuumpumpen baueinheitlich als ein Vakuumpumpstand ausgebildet sein.

Die Vakuumpumpe ist dabei mit den ersten Kammerteilen verbunden, die in der Vakuumbeschichtungsanlage insbesondere ruhend angeordnet sein können. Die zweiten Kammerteile sind dabei beweglich an der Vakuumbeschichtungsanlage angeordnet und so ausgeführt, dass sie mit jedem der ersten Kammerteile kompatibel sind. Damit wird erreicht, dass die zweiten Kammerteile mit den aufgenommenen Bauteilen von Kammer zu Kammer bewegt werden können, nämlich von einem ersten Kammerteil zum nächsten ersten Kammerteil, und jeweils dichtend an die ersten Kammerteile angebracht werden können. Erst damit ergibt sich der wesentliche Vorteil, dass die Vakuumbeschichtungsanlage mit einem Rundtakttisch ausgeführt werden kann, und die zweiten Kammerteile sind an dem Rundtakttisch aufgenommen. Mittels des Rundtakttisches können damit die zweiten Kammerteile gegenüber den ersten Kammerteilen bewegt werden.

Abweichend von der Prozessabfolge des Plasmaaktivierens, des Aufbringens der Beschichtung und der Plasmapolymerisation kann auch anstelle der Plasmaaktivierung in der Plasmaaktivierungskammer dort bereits eine Plasmapolymerisation durchgeführt werden. Technologisch sind das sehr ähnliche Prozesse. Weiterhin kann es Sonderprozesse geben, bei denen auf einen oder zwei der 3 Prozessschritte verzichtet wird.

### BEVORZUGTES AUSFÜHRUNGSBEISPIEL DER ERFINDUNG

Weitere, die Erfindung verbessernde Maßnahmen werden nachstehend gemeinsam mit der Beschreibung eines bevorzugten Ausführungsbeispiels der Erfindung anhand der Figuren näher dargestellt. Es zeigt:
- Figur 1A - Figur 1E: jeweilige Ansichten der Plasmaaktivierungskammer, der Beschichtungskammer und der Plasmapolymerisationskammer, wobei beispielhaft ein Bauteil durch die Kammern bewegt wird und
- Figur 2: eine perspektivische schematische Ansicht einer Vakuumbeschichtungsanlage mit den Merkmalen der vorliegenden Erfindung.

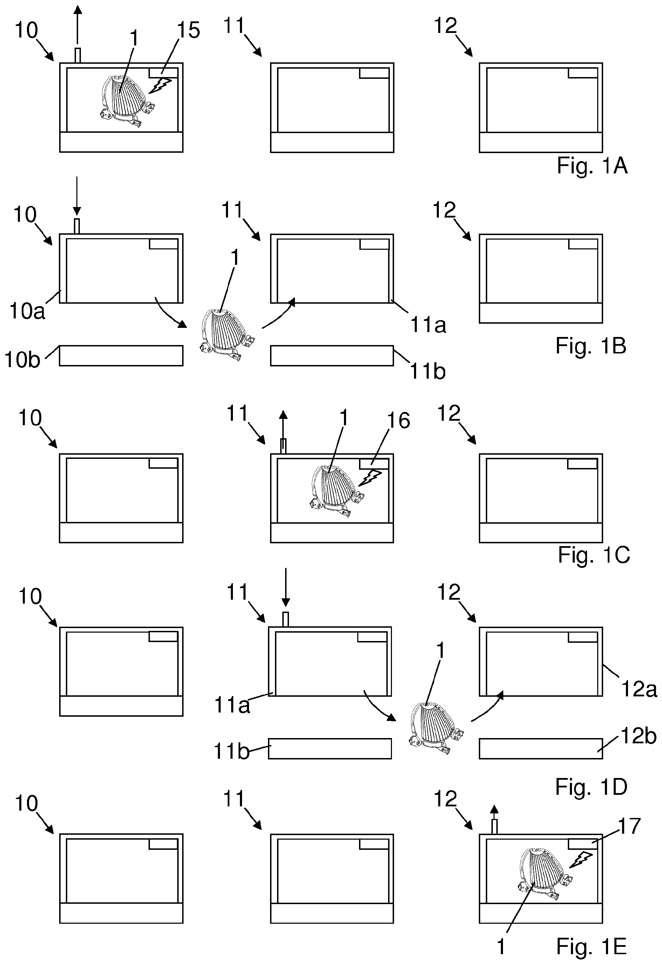

Figur 1A zeigt die Plasmaaktivierungskammer 10, die Beschichtungskammer 11 und die Plasmapolymerisationskammer 12, sodass im dargestellten Ausführungsbeispiel drei Kammern vorhanden sind, wobei das Bauteil 1 in der Plasmaaktivierungskammer 10 aufgenommen ist. In der Plasmaaktivierungskammer 10 befindet sich ein Mittel 15 zum Plasmaaktiveren, womit die zu beschichtende Oberfläche des Bauteils 1 plasmaaktiviert wird.

Figur 1B zeigt die Plasmaaktivierungskammer 10, die Beschichtungskammer 11 und die Plasmapolymerisationskammer 12, wobei die Plasmaaktivierungskammer 10 und die Beschichtungskammer 11 jeweils geöffnet sind. Die Öffnung erfolgt zwischen dem ersten Kammerteil 10a und dem zweiten Kammerteil 10b der Plasmaaktivierungskammer 10 und dem ersten Kammerteil 11a und dem zweiten Kammerteil 11b der Beschichtungskammer 11. Durch das Öffnen kann das Bauteil 1 unter Atmosphäre von der Plasmaaktivierungskammer 10 in die Beschichtungskammer 11 überführt werden.

Figur 1C zeigt die Plasmaaktivierungskammer 10, die Beschichtungskammer 11 und die Plasmapolymerisationskammer 12 in jeweils geschlossenem Zustand, und die Beschichtungskammer 11 weist ein Mittel 16 zum Aufbringen der Beschichtung auf das Bauteil 1 auf, welches Mittel 16 aktiviert ist.

Figur 1D zeigt die Plasmaaktivierungskammer 10, die Beschichtungskammer 11 und die Plasmapolymerisationskammer 12, wobei die Beschichtungskammer 11 und die Plasmapolymerisationskammer 12 jeweils geöffnet sind, indem der zweite Kammerteil 11b vom ersten Kammerteil 11a der Beschichtungskammer 11 gelöst ist, und indem der zweite Kammerteil 12b vom ersten Kammerteil 12a der Plasmapolymerisationskammer 12 gelöst ist. Das Bauteil 1 kann damit ebenfalls unter Atmosphäre von der Beschichtungskammer 11 in die Plasmapolymerisationskammer 12 überführt werden.

Figur 1E zeigt schließlich die Plasmaaktivierungskammer 10, die Beschichtungskammer 11 und die Plasmapolymerisationskammer 12 in jeweils geschlossenem Zustand, und die Plasmapolymerisationskammer 12 weist ein Mittel 17 zur Plasmapolymerisation auf, welches aktiviert ist, um das Bauteil 1 mit einer Schutzschicht auf der aufgebrachten Beschichtung zu versehen.

Die zweiten Kammerteile 10b, 11b und 12b sind getrennt voneinander geschlossen und geöffnet gezeigt. Die Vakuumbeschichtungsanlage 100 weist dabei zweite Kammerteile 10b, 11b und 12b auf, die mechanisch miteinander verbunden sind, so dass abweichend von der lediglich schematischen Darstellung grundsätzlich alle zweiten Kammerteile 10b, 11b und 12b geöffnet oder geschlossen sind.

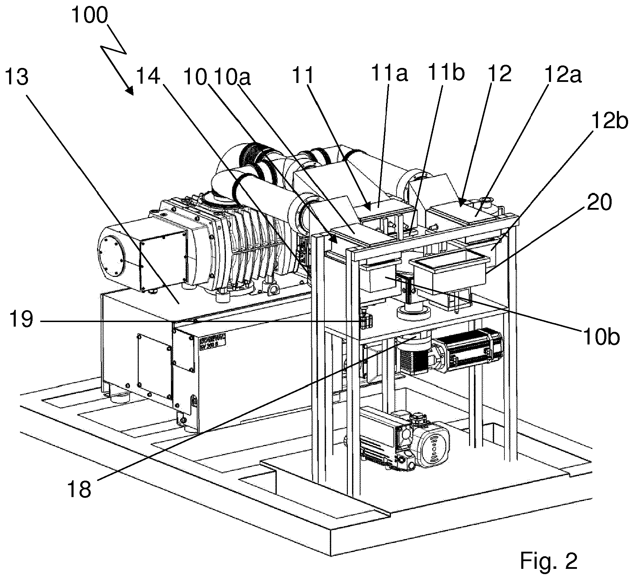

Figur 2 zeigt eine schematische perspektivische Ansicht einer Vakuumbeschichtungsanlage 100 zum Oberflächenbeschichten eines Bauteils unter Vakuum, und es ist eine Plasmaaktivierungskammer 10 zum Plasmaaktivieren der zu beschichtenden Oberfläche des Bauteils vorgesehen, weiterhin ist eine Beschichtungskammer 11 zum Aufbringen der Beschichtung vorgesehen und es ist eine Plasmapolymerisationskammer 12 zur Erzeugung einer Schutzschicht auf der aufgebrachten Beschichtung mittels einer Plasmapolymerisation vorgesehen, wobei auch nur zwei der drei Kammern vorhanden sein können.

Alle drei Kammern 10, 11 und 12 befinden sich in Anordnung an einem gemeinsamen Aufbau, und sämtliche Kammern 10, 11 und 12 sind in zwei Kammerteile unterteilt. Die Plasmaaktivierungskammer 10 weist einen ersten Kammerteil 10a und einen zweiten Kammerteil 10b auf, die Beschichtungskammer 11 weist einen ersten Kammerteil 11a und einen zweiten Kammerteil 11b auf und die Plasmapolymerisationskammer 12 weist einen ersten Kammerteil 12a und einen zweiten Kammerteil 12b auf. Die ersten Kammerteile 10a, 11a und 12a sind unbeweglich am Aufbau der Vakuumbeschichtungsanlage angeordnet und mit einer Vakuumpumpe 13 verbunden. Die unterseitig angeordneten zweiten Kammerteile 10b, 11b und 12b sind mit einem Rundtakttisch 18 verbunden und können gemeinsam mit einem Hubzylinder 19 in der Höhe verfahren werden, so dass die zweiten Kammerteile 10b, 11b und 12b gegen die ersten Kammerteile 10a, 11a und 12a dichtend zur Anlage gebracht und von diesen wieder gelöst werden können. Fährt der Hubzylinder 19 nach oben, so gelangen die zweiten Kammerteile 10b, 11b und 12b dichtend zur Anlage gegen die ersten Kammerteile 10a, 11a und 12a. Liegen die Bauteile in den jeweiligen zweiten Kammerteilen 10b, 11b und 12b ein, so können diese mit den zweiten Kammerteilen 10b, 11b und 12b verfahren werden.

Der Aufbau weist drei erste Kammerteile 10a, 11a und 12a und vier zweite Kammerteile 10b, 11b, 12b und 20 auf. Der überschüssige zweite Kammerteil 20 dient als freier Kammerteil 20, um aus diesem freien Kammerteil das oberflächenmetallisierte Bauteil 1 zu entnehmen und ein weiteres zu beschichtendes Bauteil 1 einzulegen. Die zweiten Kammerteile 10b, 11b, 12b und 20 sind zueinander gleich ausgebildet, sodass ein Wechsel der zweiten Kammerteile 10b, 11b, 12b und 20 gegenüber den ersten Kammerteilen 10a, 11a und 12a möglich wird. Die Entnahme und das Einlegen der Bauteile können dabei automatisiert erfolgen.

Zusätzlich zur Vakuumpumpe 13 ist eine Zusatzvakuumpumpe 14 eingerichtet, die lediglich mit der Beschichtungskammer 11a verbunden ist und dazu ausgebildet ist, in der Beschichtungskammer 11a ein höheres Vakuum zu erzeugen. Die Verbindung der Vakuumpumpe 13 und der Zusatzvakuumpumpe 14 erfolgt jeweils zu den ersten Kammerteilen 10a, 11a und 12a, und die Zusatzvakuumpumpe 14 ist lediglich mit dem ersten Kammerteil 11a der Beschichtungskammer 11 verbunden.

Die Erfindung wird durch die Ansprüche definiert und beschränkt sich in ihrer Ausführung nicht auf das vorstehend angegebene bevorzugte Ausführungsbeispiel. Vielmehr ist eine Anzahl von Varianten denkbar, welche von der dargestellten Lösung auch bei grundsätzlich anders gearteten Ausführungen Gebrauch macht. Sämtliche aus den Ansprüchen, der Beschreibung oder den Zeichnungen hervorgehenden Merkmale und/oder Vorteile einschließlich konstruktiver Einzelheiten, räumlicher Anordnungen und Verfahrensschritte können auch in den verschiedensten Kombinationen erfindungswesentlich sein.

### Bezugszeichenliste

- 100: Vakuumbeschichtungsanlage

- 1: Bauteil

- 10: Plasmaaktivierungskammer
- 10a: erster Kammerteil
- 10b: zweiter Kammerteil
- 11: Beschichtungskammer
- 11a: erster Kammerteil
- 11b: zweiter Kammerteil
- 12: Plasmapolymerisationskammer
- 12a: erster Kammerteil
- 12b: zweiter Kammerteil
- 13: Vakuumpumpe
- 14: Zusatzvakuumpumpe
- 15: Mittel zum Plasmaaktivieren
- 16: Mittel zum Aufbringen der Beschichtung
- 17: Mittel zur Plasmapolymerisation
- 18: Rundtakttisch
- 19: Hubzylinder
- 20: zweiter Kammerteil

## Patentansprüche

1. Verfahren zum Oberflächenbeschichten eines Bauteils (1) unter Vakuum mittels einer Vakuumbeschichtungsanlage (100), wobei das Verfahren wenigstens zwei der nachfolgend genannten Prozessschritte umfasst:
a) Plasmaaktivieren der zu beschichtenden Oberfläche des Bauteils (1) in einer evakuierten Plasmaaktivierungskammer (10) und/oder
b) Aufbringen der Beschichtung in einer evakuierten Beschichtungskammer (11) und/oder
c) Plasmapolymerisation zur Erzeugung einer Schutzschicht auf der aufgebrachten Beschichtung in einer evakuierten Plasmapolymerisationskammer (12),
**dadurch gekennzeichnet, dass** zwischen wenigstens zwei der genannten Prozessschritte die Plasmaaktivierungskammer (10) und/oder die Beschichtungskammer (11) und/oder die Plasmapolymerisationskammer (12) belüftet und geöffnet werden, und das Bauteil (1) dem nachfolgenden Prozessschritt zugeführt wird.

2. Verfahren nach Anspruch 1, **dadurch gekennzeichnet, dass** nach dem Plasmaaktivieren die Plasmaaktivierungskammer (10) belüftet und geöffnet wird und das Bauteil (1) aus der Plasmaaktivierungskammer (10) in die Beschichtungskammer (11) überführt wird und/oder dass
- nach dem Aufbringen der Beschichtung die Beschichtungskammer (11) belüftet und geöffnet wird und das Bauteil (1) aus der Beschichtungskammer (11) in die Plasmapolymerisationskammer (12) überführt wird.

3. Verfahren nach Anspruch 1 oder 2, **dadurch gekennzeichnet, dass** mehrere Bauteile (1) in einer Taktfolge hintereinander in der Vakuumbeschichtungsanlage (100) beschichtet werden, wobei das Evakuieren, das Belüften und das Öffnen der Plasmaaktivierungskammer (10), der Beschichtungskammer (11) und der Plasmapolymerisationskammer (12) jeweils gleichzeitig ausgeführt wird.

4. Verfahren nach einem der Ansprüche 1 bis 3, **dadurch gekennzeichnet, dass** das Vakuum in der Plasmaaktivierungskammer (10), in der Beschichtungskammer (11) und in der Plasmapolymerisationskammer (12) mittels einer gemeinsamen Vakuumpumpe (13) gleichzeitig erzeugt wird.

5. Verfahren nach einem der vorgenannten Ansprüche, **dadurch gekennzeichnet, dass** zur stärkeren Evakuierung der Beschichtungskammer (11) eine Zusatzvakuumpumpe (14) vorhanden ist, die nach der gemeinsamen Evakuierung der Plasmaaktivierungskammer (10), in der Beschichtungskammer (11) und in der Plasmapolymerisationskammer (12) durch die Vakuumpumpe (13) zur noch weiteren Evakuierung der Beschichtungskammer (11) aktiviert wird.

6. Verfahren nach einem der vorgenannten Ansprüche, **dadurch gekennzeichnet, dass** die Prozessschritte des Einführens der Bauteile (1), des Evakuierens, des jeweiligen Prozessablaufes, des Belüftens und des Öffnens der Plasmaaktivierungskammer (10), der Beschichtungskammer (11) und der Plasmapolymerisationskammer (12) zeitgleich erfolgen.

7. Vakuumbeschichtungsanlage (100) zum Oberflächenbeschichten eines Bauteils (1) unter Vakuum, aufweisend:
- eine Plasmaaktivierungskammer (10) zum Plasmaaktivieren der zu beschichtenden Oberfläche des Bauteils (1) und
- eine Beschichtungskammer (11) zum Aufbringen der Beschichtung und
- eine Plasmapolymerisationskammer (12) zur Erzeugung einer Schutzschicht auf der aufgebrachten Beschichtung mittels einer Plasmapolymerisation, wobei die Plasmaaktivierungskammer (10), die Beschichtungskammer (11) und die Plasmapolymerisationskammer (12) jeweils einen ersten Kammerteil (10a, 11a, 12a) aufweisen, in denen Mittel zum Plasmaaktivieren (15), Mittel zum Aufbringen der Beschichtung (16) und/oder Mittel zur Plasmapolymerisation (17) ausgebildet sind, und wobei die Plasmaaktivierungskammer (10), die Beschichtungskammer (11) und die Plasmapolymerisationskammer (12) jeweils einen zweiten Kammerteil (10b, 11b, 12b) aufweisen, die zur Aufnahme des Bauteils (1) ausgebildet sind,
**dadurch gekennzeichnet, dass** die zweiten Kammerteile (10b, 11b, 12b) gegen die ersten Kammerteile (10a, 11a, 12a) beweglich angeordnet sind und somit bei einem Wechsel der Bauteile (1) zwischen wenigstens zwei Prozessschritten belüftbar, taktweise wechselbar, wieder schließbar und evakuierbar sind.

8. Vakuumbeschichtungsanlage (100) nach Anspruch 7, **dadurch gekennzeichnet, dass** eine Vakuumpumpe (13) eingerichtet ist, mit der das Vakuum in der Plasmaaktivierungskammer (10), in der Beschichtungskammer (11) und/oder in der Plasmapolymerisationskammer (12) mittels einer gemeinsamen Vakuumpumpe (13) gleichzeitig erzeugbar ist.

9. Vakuumbeschichtungsanlage (100) nach Anspruch 8, **dadurch gekennzeichnet, dass** die Vakuumpumpe (13) mit den ersten Kammerteilen (10a, 11a, 12a) verbunden ist.

10. Vakuumbeschichtungsanlage (100) nach einem der Ansprüche 7 bis 9, **dadurch gekennzeichnet, dass** die zweiten Kammerteile (10b, 11b, 12b) aller Kammern (10, 11, 12) kompatibel ausgebildet sind zu den ersten Kammerteilen (10a, 11a, 12a) aller Kammern (10, 11, 12).

11. Vakuumbeschichtungsanlage (100) nach einem der Ansprüche 7 bis 10, **dadurch gekennzeichnet, dass** die zweiten Kammerteile (10b, 11b, 12b) auf einem Rundtakttisch (18) aufgenommen sind und mittels des Rundtakttisches (18) gegenüber den ersten Kammerteilen (10a, 11a, 12a) bewegbar sind.

## Claims

1. Procedure for coating surfaces of a component (1) under vacuum using a vacuum coating system (100), whereby the procedure includes at least two of the following process steps:
a) plasma activation of the component surface to be coated (1) in an evacuated plasma activation chamber (10) and/or
b) applying the coat in an evacuated coating chamber (11) and/or
c) plasma polymerization to create a protective layer on the applied coat in an evacuated plasma polymerization chamber (12),
**wherein** the plasma activation chamber (10) and/or coating chamber (11) and/or plasma polymerization chamber (12) are ventilated and opened between at least two of the aforementioned process steps, and the component (1) is fed to the subsequent process step.

2. Procedure in accordance with Claim 1, **wherein** the plasma activation chamber (10) is ventilated and opened after plasma activation and the component (1) from the plasma activation chamber (10) is transferred to the coating chamber (11) and/or
- the coating chamber (11) is ventilated and opened after the coat is applied and the component (1) from the coating chamber (11) is transferred to the plasma polymerization chamber (12).

3. Procedure in accordance with Claim 1 or 2, **wherein** several components (1) are coated consecutively in a cycle sequence in the vacuum coating plant (100), whereby evacuation, ventilation and opening of the plasma activation chamber (10), coating chamber (11) and plasma polymerization chamber (12) are performed simultaneously.

4. Procedure in accordance with one of Claims 1 through 3, **wherein** the vacuum is generated simultaneously in the plasma activation chamber (10), in the coating chamber (11) and in the plasma polymerization chamber (12) using a shared vacuum pump (13).

5. Procedure in accordance with one of the aforementioned claims, **wherein,** for more powerful evacuation of the coating chamber (11), there is an auxiliary vacuum pump (14) that is activated in the coating chamber (11) and plasma polymerization chamber (12) by the vacuum pump (13) for further evacuation of the coating chamber (11) after joint evacuation of the plasma activation chamber (10).

6. Procedure in accordance with one of the aforementioned claims, **wherein** the process steps for inserting components (1), evacuation, the respective process flow, ventilation and opening the plasma activation chamber (10), coating chamber (11) and plasma polymerization chamber (12) are carried out simultaneously.

7. Vacuum coating system (100) for coating the surfaces of a component (1) under vacuum that features the following:
- a plasma activation chamber (10) for plasma activation of the component surface to be coated (1) and
- a coating chamber (11) for applying the coat and
- a plasma polymerization chamber (12) for creating a protective coating on the applied coat using plasma polymerization, whereby the plasma activation chamber (10), coating chamber (11) and/or plasma polymerization chamber (12) each feature a first chamber part (10a, 11a, 12a), in which tools for plasma activation (15), applying the coat (16) and/or plasma polymerization (17) are designed, and whereby the plasma activation chamber (10), coating chamber (11) and/or plasma polymerization chamber (12) each have a second chamber part (10b, 11b, 12b) that is designed to hold the component (1), **wherein** the second chamber parts (10b, 11b, 12b) are arranged against the first chamber parts (10a, 11a, 12a) so they can move and, as a result, can be ventilated, switched in cycles, closed again and evacuated between at least two process steps when the components (1) are switched.

8. Vacuum coating system (100) in accordance with Claim 7, **wherein** a vacuum pump (13) is set up that can be used to generate the vacuum simultaneously in the plasma activation chamber (10), coating chamber (11) and/or plasma polymerization chamber (12) using a shared vacuum pump (13).

9. A vacuum coating system (100) in accordance with Claim 8, **wherein** the vacuum pump (13) is connected to the first chamber parts (10a, 11a, 12a).

10. Vacuum coating system (100) in accordance with one of Claims 7 through 9 **wherein** the second chamber parts (10b, 11b, 12b) of all chambers (10, 11, 12) have a design compatible with the first chamber parts (10a, 11a, 12a) of all chambers (10, 11, 12).

11. Vacuum coating system (100) in accordance with Claims 7 through 10, **wherein** the second chamber parts (10b, 11b, 12b) are held in a rotary indexing table (18) and can be moved against the first chamber parts (10a, 11a, 12a) using the rotary indexing table (18).

## Revendications

1. Procédé pour le revêtement de surface d'un composant (1) sous vide au moyen d'une installation pour revêtement sous vide (100), le procédé comprenant au moins deux des étapes de procédé mentionnées ci-après :
a) Activation par plasma de la surface du composant (1) à revêtir dans une chambre d'activation par plasma sous vide (10) et/ou
b) Application du revêtement dans une chambre de revêtement sous vide (11) et/ou
c) Polymérisation par plasma pour générer une couche protectrice sur le revêtement appliqué dans une chambre de polymérisation par plasma sous vide (12),
**caractérisé en ce qu'**entre au moins deux étapes de procédé mentionnées, la chambre d'activation par plasma (10) et/ou la chambre de revêtement (11) et/ou la chambre de polymérisation par plasma (12) sont ventilées et ouvertes et que le composant (1) est amené à l'étape de procédé suivante.

2. Procédé selon la revendication 1, **caractérisé en ce qu'**après l'activation par plasma, la chambre d'activation par plasma (10) est ventilée et ouverte et que le composant (1) est transféré de la chambre d'activation par plasma (10) à la chambre de revêtement (11) et/ou **en ce que**,
après l'application du revêtement, la chambre de revêtement (11) est ventilée et ouverte et que le composant (1) est transféré de la chambre de revêtement (11) à la chambre de polymérisation par plasma (12).

3. Procédé selon la revendication 1 ou 2, **caractérisé en ce que** plusieurs composants (1) sont revêtus l'un après l'autre dans une séquence de cycles dans l'installation pour revêtement sous vide (100), l'évacuation, la mise à l'air libre et l'ouverture de la chambre d'activation par plasma (10), de la chambre de revêtement (11) et de la chambre de polymérisation par plasma (12) étant effectuées simultanément.

4. Procédé selon l'une des revendications 1 à 3, **caractérisé en ce que** le vide dans la chambre d'activation par plasma (10), dans la chambre de revêtement (11) et dans la chambre de polymérisation par plasma (12) est généré simultanément au moyen d'une pompe à vide commune (13).

5. Procédé selon l'une des revendications précitées, **caractérisé en ce qu'**une pompe à vide supplémentaire (14) est prévue pour une évacuation plus importante de la chambre de revêtement (11), cette pompe à vide supplémentaire étant activée par la pompe à vide (13) après l'évacuation commune de la chambre d'activation par plasma (10), dans la chambre de revêtement (11) et dans la chambre de polymérisation par plasma (12) pour une évacuation encore plus poussée de la chambre de revêtement (11).

6. Procédé selon l'une des revendications précitées, **caractérisé en ce que** les étapes de processus telles que l'introduction des composants (1), l'établissement du vide, le déroulement du processus correspondant, la ventilation et l'ouverture de la chambre d'activation par plasma (10), de la chambre de revêtement (11) et de la chambre de polymérisation par plasma (12) sont réalisées simultanément.

7. Installation pour revêtement sous vide (100) de la surface d'un composant (1) comprenant :
- une chambre d'activation par plasma (10) pour l'activation par plasma de la surface du composant (1) à revêtir, et
- une chambre de revêtement (11) pour l'application du revêtement et
- une chambre de polymérisation par plasma (12) pour générer une couche protectrice sur le revêtement appliqué au moyen de la polymérisation par plasma, sachant que la chambre d'activation par plasma (10), la chambre de revêtement (11) et la chambre de polymérisation par plasma (12) comprennent chacune une première partie de chambre (10a, 11a, 12a) dans lesquelles sont constitués des agents d'activation par plasma (15), d'application du revêtement (16) et/ou de polymérisation par plasma (17) et sachant que la chambre d'activation par plasma (10), la chambre de revêtement (11) et la chambre de polymérisation par plasma (12) présentent chacune une deuxième partie de chambre (10b, 11b, 12b) qui sont conçues pour recevoir le composant (1),
**caractérisée en ce que** les deuxièmes parties de chambre (10b, 11b, 12b) sont disposées de manière mobile contre les premières parties de chambre (10a, 11a, 12a) et peuvent ainsi être ventilées, échangées cycliquement, refermées et mises sous vide lors d'un changement de composants (1) entre au moins deux étapes de processus.

8. Installation pour revêtement sous vide (100) selon la revendication 7, **caractérisée en ce qu'**une pompe à vide (13) est configurée avec laquelle le vide dans la chambre d'activation par plasma (10), dans la chambre de revêtement (11) et/ou dans la chambre de polymérisation par plasma (12) peut être généré simultanément au moyen d'une pompe à vide commune (13).

9. Installation pour revêtement sous vide (100) selon la revendication 8, **caractérisée en ce que** la pompe à vide (13) est reliée aux premières parties de chambre (10a, 11a, 12a).

10. Installation pour revêtement sous vide (100) selon l'une des revendications 7 à 9, **caractérisée en ce que** les secondes parties de chambre (10b, 11b, 12b) de toutes les chambres (10, 11, 12) sont conçues pour être compatibles avec les premières parties de chambre (10a, 11a, 12a) de toutes les chambres (10, 11, 12).

11. Installation pour revêtement sous vide (100) selon l'une des revendications 7 à 10, **caractérisée en ce que** les secondes parties de chambre (10b, 11b, 12b) sont logées sur une table indexée rotative (18) et sont mobiles par rapport aux premières parties de chambre (10a, 11a, 12a) au moyen de la table indexée rotative (18).
